(19) Europäisches Patentamt
European Patent Office
Office européen des brevets

(11) Veröffentlichungsnummer: **0 274 354 B1**

(12) **EUROPÄISCHE PATENTSCHRIFT**

(45) Veröffentlichungstag der Patentschrift: **08.01.92**

(51) Int. Cl.[5]: **C08L 79/08**, G03F 7/004, C08G 73/10

(21) Anmeldenummer: **87810771.3**

(22) Anmeldetag: **21.12.87**

(54) **Photostrukturierbare Polyimidmischungen, Polyimide auf Basis von Benzhydroltetracarbonsäure und deren Herstellung.**

(30) Priorität: **29.12.86 CH 5225/86**

(43) Veröffentlichungstag der Anmeldung:
**13.07.88 Patentblatt 88/28**

(45) Bekanntmachung des Hinweises auf die Patenterteilung:
**08.01.92 Patentblatt 92/02**

(84) Benannte Vertragsstaaten:
**BE CH DE FR GB IT LI NL SE**

(56) Entgegenhaltungen:
**EP-A- 0 132 221**
**EP-A- 0 134 752**
**EP-A- 0 162 017**
**EP-A- 0 181 837**

(73) Patentinhaber: **CIBA-GEIGY AG**
**Klybeckstrasse 141**
**CH-4002 Basel(CH)**

(72) Erfinder: **Rohde, Ottmar, Dr.**
**Bärenfelserstrasse 34**
**CH-4057 Basel(CH)**
Erfinder: **Perret, André-Etienne, Dr.**
**Verger 3**
**CH-2206 Les Geneveys-sur-Coffrane(CH)**
Erfinder: **Pfeifer, Josef, Dr.**
**Brunnmattstrasse 32**
**CH-4106 Therwil(CH)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



Rank Xerox (UK) Business Services

## Beschreibung

Die vorliegende Erfindung betrifft Polyimide auf Basis von Benzhydroltetracarbonsäure (derivaten) und ausgewählten Diaminresten, Zusammensetzungen enthaltend lösliche, photostrukturierbare Polyimide und besagte Benzhydrolpolyimide, ein Verfahren zur Herstellung von Schutzüberzügen und Reliefabbildungen und die Verwendung besagter Polyimidgemische zur Herstellung von Isolier-, Passivier- und Schutzschichten und von Reliefabbildungen.

Lösliche und gleichzeitig photostrukturierbare Polyimide sind bekannt. In den EP-A 132,221, 134,752, 162,017 und 181,837 werden autophotovernetzbare Polyimide beschrieben.

Aus den EP-A 92,524 und 141,781 sind strahlungsempfindliche Beschichtungsmittel bekannt, die ein lösliches Polyimid und mindestens ein Vernetzungsmittel, beispielsweise ein organisches Polyazid, enthalten.

Photostrukturierbare Polyimide sind als Schutzschichten oder Aetzmasken bei der Herstellung elektronischer Bauteile von potentiellem Interesse. Schichten aus diesen Materialien sind hoch temperaturbeständig und chemisch inert, so dass sie auch in Prozesschritten eingesetzt werden können, bei denen hohe Temperaturen und aggressive chemische Bedingungen vorliegen.

Das Haftvermögen einer Reihe von Polyimiden ist auf verschiedenen Substraten jedoch nicht befriedigend. Deshalb verwendet man sogenannte Haftvermittler, die in der Regel auf das jeweilige System (Substrat/Polyimid) abgestimmt sein müssen. Die Haftung solcherart modifizierter Schichten ist jedoch nicht in jedem Falle ausreichend. So zeigt sich, dass bei Aetzprozessen mit aggressiven Medien, beispielsweise mit Flussäure, die Aetzmasken an der Substrat-/Polyimidgrenzflächeangegriffen werden, die Schutzschicht sich teilweise ablöst oder die zu schützende Substratoberfläche stark angeätzt wird. Unter solchen Bedingungen ist die Haftung also unzureichend, und Aetzprozesse sind mit solchen Systemen nicht möglich oder es entstehen Aetzmuster mit geringer Auflösung.

Daher kann man auch einen Aetzprozess, wie z.B. die Anwendung von Flussäure, dazu benutzen, um das Haftvermögen einer Polyimidschicht auf Substraten, beispielsweise $SiO_2$, zu bestimmen.

Polyimide auf Basis von Benzhydroltetracarbonsäuren oder deren Derivaten sind aus der EP-A 77, 718 oder den US-Patenten 3,933,745 und 3,793,291 bekannt. Diese Verbindungen sind gut in organischen Lösungsmitteln löslich und zeichnen sich durch eine gute Haftung auf unterschiedlichen Substraten aus. Diese Polyimide sind allerdings nicht photovernetzbar.

Die Verwendung von Mischsystemen aus photostrukturierbaren Polyimiden, insbesondere den Polyimiden der oben genannten Patentanmeldungen und Patente, und anderen Polymeren, insbesondere haftvermittelnden Polymeren, ist nicht unproblematische. In der Regel sinkt die Photoempfindlichkeit des Mischsystems gegenüber dem reinen photovernetzbaren Polyimid auf ein nicht tolerierbares Mass ab oder die Thermostabilität der Mischung lässt zu wünschen übrig. Ferner kann die Verwendung mehr als einer Polymerkomponente zu Problemen bei der Herstellung von hochaufgelösten Reliefstrukturen führen, weil keine homogene Mischung vorliegt und somit kein einheitlich strukturierter Film entsteht.

Es wurde jetzt eine ausgewählte Klasse von Polyimiden gefunden, die sich mit ausgewählten photostrukturierbaren Polyimiden zu gut haftenden, thermostabilen Mischungen mit guter Photoempfindlichkeit kombinieren lassen.

Die vorliegende Erfindung betrifft Zusammensetzungen enthaltend

a) 50-1 Gew.%, bezogen auf die Gesamtmenge aus a) und b), mindestens eines Polyimids mit einer inhärenten Viskosität von mindestens 0,1 dl/g (gemessen an einer 0,5 gew.%igen Lösung in N-Methylpyrrolidon bei 25° C) enthaltend mindestens 50 Mol% an Struktureinheiten der Formel I

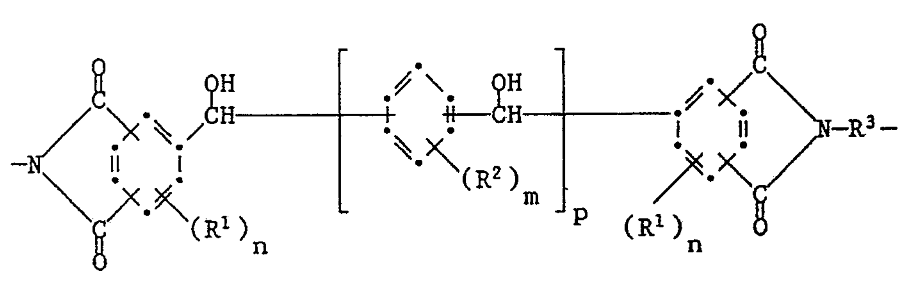 (I),

worin m und p unabhängig voneinander ganze Zahlen von 0 bis 4 und n eine ganze Zahl von 0 bis 3 bedeuten,

$R^1$ und $R^2$ unabhängig voneinander $C_1$-$C_6$-Alkyl oder $C_1$-$C_6$-Alkoxy bedeuten und

$R^3$ ein zweiwertiger Rest eines aromatischen Diamins ist, der in wenigstens einer Orthostellung zu wenigstens einem N-Atom durch Alkyl, Alkoxy, Alkoxyalkyl, Cycloalkyl oder Aralkyl substituiert ist, oder bei dem zwei benachbarte C-Atome des aromatischen Restes durch Alkylen substituiert sind, und

b) 50-99 Gew.%, bezogen auf die Gesamtmenge aus a) und b), mindestens eines in organischen Lösungsmitteln löslichen und photovernetzbaren aromatischen Polyimids, das wenigstens 50 Mol% an Strukturelementen der Formel II

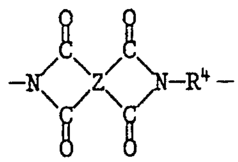

(II),

enthält, worin Z ein vierwertiger aromatischer Rest der Formeln III, IV, V und/oder VI ist, bei dem jeweils zwei der freien Valenzen in ortho-oder peri-Stellung zueinander gebunden sind

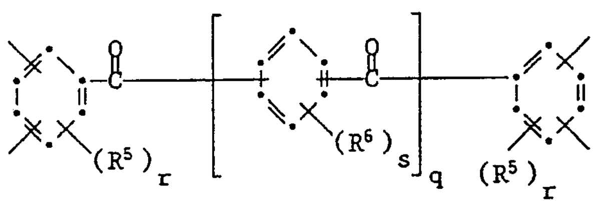

(III),

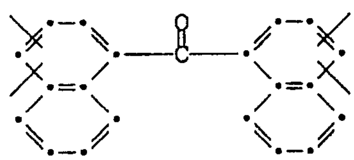

(IV),

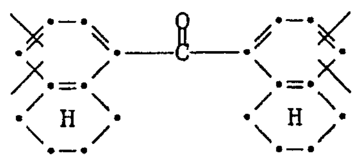

(V),

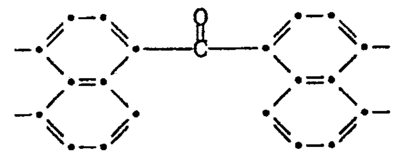

(VI),

worin $R^5$ und $R^6$ unabhängig voneinander $C_1$-$C_6$-Alkyl oder $C_1$-$C_6$-Alkoxy sind,
q und s unabhängig voneinander ganze Zahlen von 0 bis 4 bedeuten,
r eine ganze Zahl von 0 bis 3 ist, und
$R^4$ ein zweiwertiger Rest eines aromatischen Diamins ist, der in zwei Orthostellungen zu wenigstens einem N-Atom durch Alkyl, Alkoxy, Alkoxyalkyl, Cycloalkyl oder Aralkyl substituiert ist, oder bei dem zwei benachbarte C-Atome des aromatischen Restes durch Alkylen substituiert sind, und

c) als Cokomponente für a) und b) aromatische Polyimidreste der Formel IIa

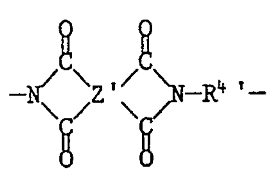

(IIa),

worin Z' ein vierwertiger aromatischer Rest der Formeln

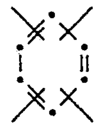 , 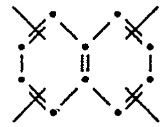 ,

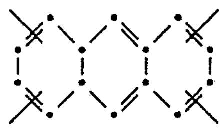 , 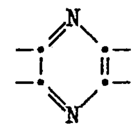 , 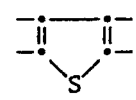

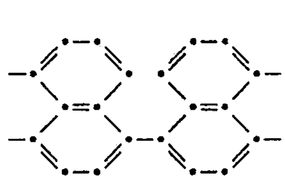 , 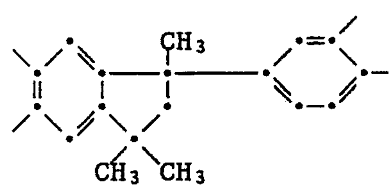

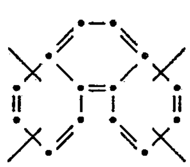 oder 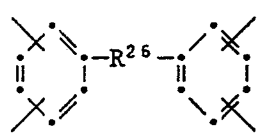

ist, in denen sich jeweils zwei der freien Valenzen in ortho- oder peri-Stellung zueinander befinden und worin $R^{26}$ eine direkte Bindung oder eine Brückengruppe der Formeln $-CH_2-$, $-C(CH_3)_2-$, -O-, -S-, $-SO_2-$, -NH-, $-C(CF_3)_2-$ oder $-Si(CH_3)_2-$ist, und $R^{4'}$ ein zweiwertiger aromatischer Kohlenwasserstoffrest mit 6 bis 24 C-Atomen ist.

Der Begriff "in organischen Lösungsmitteln lösliches und photovernetzbares Polyimid" umfasst sowohl lösliche und autophotovernetzbare Polyimide, wie oben definiert, als auch Kombinationen dieser Polyimide mit einem strahlungsaktivierbaren Vernetzungsmittel.

Bevorzugte Polyimide und Polyimidgemische die als Komponente b) eingesetzt werden können, sind aus den EP-A-132,221, -162,017 und -181,837 bekannt.

Bedeuten irgendwelche Reste Alkyl, so handelt es sich um geradkettige oder verzweigte Gruppen. Bevorzugt werden $C_1$-$C_6$-Alkylgruppen. Beispiele dafür sind Methyl, Ethyl, Propyl, Isopropyl, n-Butyl, sek.-Butyl, n-Pentyl oder n-Hexyl. Besonders bevorzugter Alkylrest ist Methyl.

Bedeuten irgendwelche Reste Cycloalkyl, so handelt es sich in der Regel um monocyclische Reste mit fünf oder sechs Ringkohlenstoffatomen. Bevorzugt wird Cyclohexyl.

Bedeuten irgendwelche Reste Alkoxy, so handelt es sich um geradkettige oder verzweigte Gruppen, Bevorzugt werden $C_1$-$C_6$-Alkoxygruppen. Beispiele dafür sind Methoxy, Ethoxy, n-Propoxy, Isopropoxy, n-Butoxy, sek.-Butoxy, n-Pentyloxy oder n-Hexyloxy. Besonders bevorzugt wird Methoxy.

Bedeuten irgendwelche Reste Alkoxyalkyl, so handelt es sich um geradkettige oder verzweigte Reste. Bevorzugt werden Alkoxyalkylgruppen mit zwei bis sechs C-Atomen. Beispiele dafür sind Methoxymethyl, Methoxyethyl, Ethoxymethyl, Ethoxyethyl oder n-Propoxypropyl.

Bedeuten irgendwelche Reste Aralkyl, so handelt es sich dabei in der Regel um Benzylgruppen oder substituierte Benzylgruppen, Beispiele dafür sind Benzyl, α-Methylbenzyl oder α,α-Dimethylbenzyl. Bevorzugt wird Benzyl.

Sind zwei benachbarte C-Atome eines aromatischen Restes durch Alkylen substituiert, so handelt es sich bei diesen Substituenten in der Regel um Tri- oder Tetramethylen, bevorzugt um Tetramethylen.

Bevorzugte Komponenten b) sind Polyimide enthaltend wenigstens 90 Mol% an Strukturelementen der Formel II, wie oben definiert, worin Z ein Rest der Formel IIIa, IIIb oder IIIc ist oder ein Gemisch dieser Reste ist

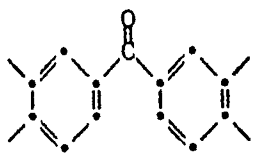 (IIIa), 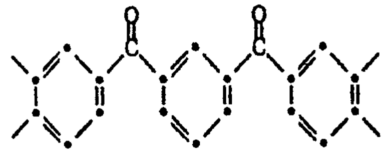 (IIIb),

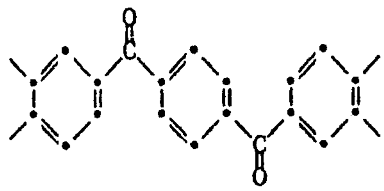 (IIIc),

und worin $R^4$ ein zweiwertiger Reste eines aromatischen Diamins ist, der in zwei Orthostellungen zu wenigstens einem N-Atom durch $C_1$-$C_6$-Alkyl substituiert ist.

In einer besonders bevorzugten Ausführungsform enthalten die erfindungsgemässen Zusammensetzungen als Komponente b) Polyimide mit dem Strukturelement der Formel II, wie oben definiert, worin $R^4$ ein Rest der Formel VII, VIII und/oder IX ist

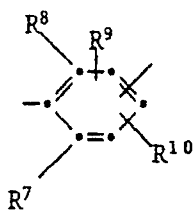 (VII), 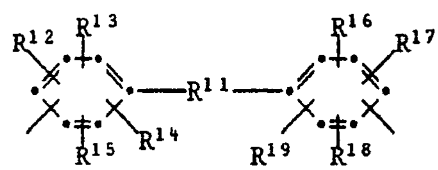 (VIII),

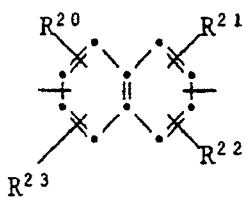 (IX),

worin die Reste $R^7$ bis $R^{10}$ und $R^{12}$ bis $R^{23}$ unabhängig voneinander Wasserstoff oder $C_1$-$C_6$-Alkyl sind und $R^{11}$ eine direkte C-C Bindung, $-CH_2-$, $-C(CH_3)_2-$, $-C(CF_3)_2-$, -O-, -CO- oder $-SO_2-$ ist, mit der Massgabe, dass jeder Rest der Formel VII, VIII oder IX wenigstens zwei $C_1$-$C_6$-Alkylreste besitzt, die in beiden Orthostellungen zu einer freien Valenz gebunden sind.

Besonders bevorzugte Komponenten b) sind Polyimide die wenigstens 90 Mol% an Strukturelementen der Formel II enthalten, worin $R^4$ ein Rest der Formeln VIIa, VIIb, VIIc oder VIIIa ist oder ein Gemisch solcher Reste ist

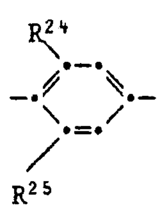 (VIIa), 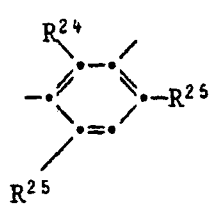 (VIIb), 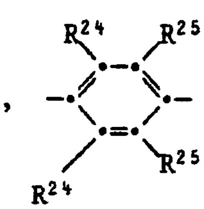 (VIIc),

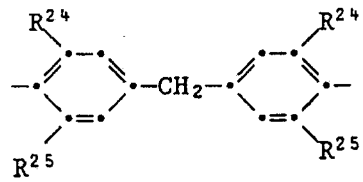 (VIIa),

worin $R^{24}$ und $R^{25}$ $C_1$-$C_6$-Alkyl bedeuten.

Ganz besonders bevorzugte Zusammensetzungen dieser Erfindung enthalten als Komponente b) Polyimide, die aus wiederkehrenden Struktureinheiten der Formel II bestehen.

Die Reste $R^5$ und $R^6$ sind vorzugsweise Methyl, Ethyl oder Methoxy, ganz besonders bevorzugt jedoch Methyl.

Die Indizes q, r und s sind vorzugsweise 0 oder 1, ganz besonders bevorzugt jedoch 0.

Aromatische Cokomponenten mit Polyimidresten der Formel IIa sind an sich bekannt und beispielsweise in den weiter oben zitierten EP-A betreffend Polyimide beschrieben.

Beispiele für Reste $R^{4'}$ in der Formel IIa sind Phenylen- oder Naphthylenreste, die gegebenenfalls substituiert sein können. Beispiele für Substituenten sind $C_1$-$C_6$-Alkyl, $C_1$-$C_6$-Alkoxy oder Halogenatome, wie Chlor. Bevorzugte Reste $R^{4'}$ sind Gruppen der Formel IIb

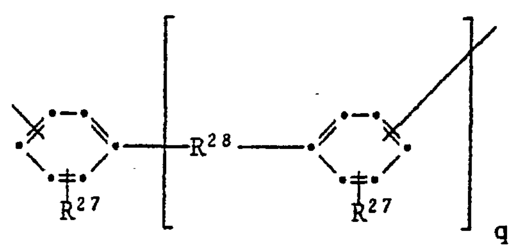 (IIb) ,

worin $R^{27}$ Wasserstoff oder $C_1$-$C_6$-Alkyl ist, q 0 oder 1 ist und $R^{28}$ die für $R^{26}$ gegebene Definition besitzt.

Weitere bevorzugte Reste $R^{4'}$ sind die weiter oben unter den Formeln VII, VIII und IX aufgezählten Reste.

Bevorzugte Zusammensetzungen enthalten als Komponente a) (Co)polyimide der Formel I, worin p 0 oder 1 ist, insbesondere jedoch 0 bedeutet, $R^3$ ein Rest der weiter oben definierten Formel VIII ist und $R^{11}$ -CO- bedeutet.

Diese Zusammensetzungen zeichnen sich durch eine besonders hohe Photoempfindlichkeit aus.

Die Polyimide enthalten mindestens 50 Mol% an Struktureinheiten der Formel I (Komponente a), worin $R^3$ ein zweiwertiger Rest eines aromatischen Diamins ist, der in zwei Orthostellungen zu wenigstens einem N-Atom durch Alkyl, Alkoxy, Alkoxyalkyl, Cycloalkyl oder Aralkyl substituiert ist, oder bei dem zwei benachbarte C-Atome des aromatischen Restes durch Alkylen substituiert sind, sind neu und ebenfalls Gegenstand der Erfindung.

Die Indizes n und m sind vorzugsweise 0.

Der Index p ist vorzugsweise 0 oder 1, besonders bevorzugt 0.

Die Reste $R^1$ und $R^2$ sind vorzugsweise Methyl oder Methoxy, insbesondere jedoch Methyl.

Ganz besonders bevorzugt werden Polyimide, die aus wiederkehrenden Struktureinheiten der Formel I bestehen.

Weitere bevorzugte Polyimide enthalten mindestens 50 Mol%, insbesondere 100 Mol%, der Struktureinheiten der Formel X, XI und/oder XII

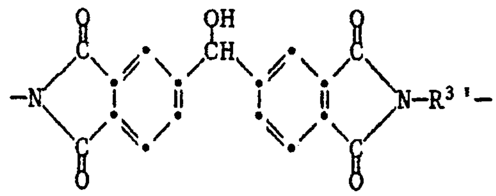

(X),

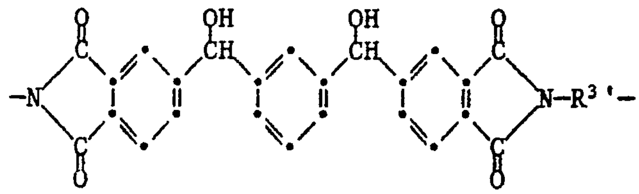

(XI),

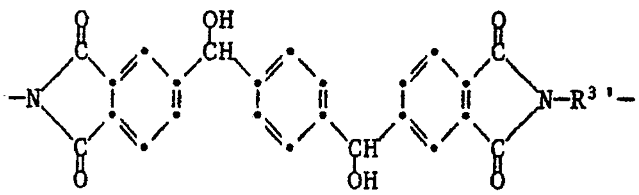

(XII),

worin $R^{3'}$ die weiter oben für $R^4$ definierte Bedeutung besitzt.

Ganz besonders bevorzugt handelt es sich bei $R^3$ um einen zweiwertigen aromatischen Rest, der in zwei Orthostellungen zu wenigstens einem N-Atom durch $C_1$-$C_6$-Alkyl oder $C_1$-$C_6$-Alkoxy, insbesondere durch $C_1$-$C_6$-Alkyl, substituiert ist.

Besonders bevorzugte Reste $R^3$ dieses Typs sind Gruppen der Formeln VII, VIII und IX und insbesondere der Formeln VIIa, VIIb, VIIc und VIIa, wie sie bereits weiter oben für $R^4$ als bevorzugt definiert wurden.

Ein weiterer besonders bevorzugter Rest $R^3$ entspricht der Formel VIIIb

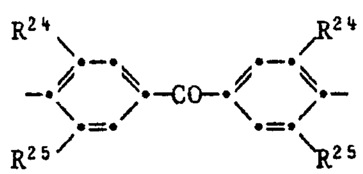

(VIIIb),

worin $R^{24}$ und $R^{25}$ die weiter oben definierte Bedeutung besitzen.

Copolyimide enthaltend das Strukturelement der Formeln I enthalten als Cokomponenten in der Regel aromatischen Imidgruppen, beispielsweise Strukturelemente der Formel IIa, wie weiter oben definiert. Die (Co)polyimide enthaltend das Strukturelement der Formel I können nach an sich bekannten Verfahren hergestellt werden; beispielsweise durch Kondensation von den entsprechenden Tetracarbonsäurenhalbestern mit den Diaminen oder Diamingemischen. Die Herstellung von Polyimiden auf Basis von Benzhydroltetracarbonsäuren ist beispielsweise in der EP-A 77,718 beschrieben.

Die Polyimide enthaltend Struktureinheiten der Formel I können ferner durch katalytische Hydrierung von Polyimiden enthaltend mindestens 50 Mol% an Struktureinheiten der Formel Ia erhalten werden

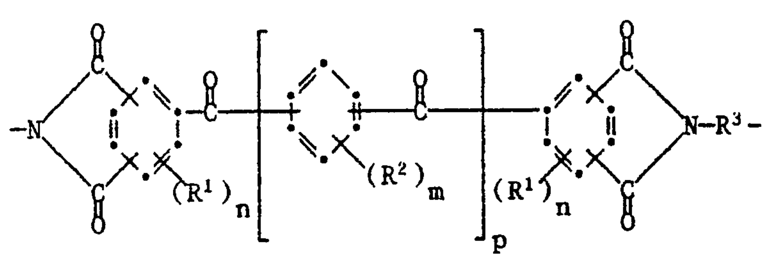

(Ia);

dabei haben die Reste $R^1$, $R^2$ und $R^3$ sowie die Indizes m, n und p die weiter oben definierte Bedeutung. Dieses Verfahren ist ebenfalls Gegenstand der vorliegenden Erfindung.

$R^3$ ist bei diesem Verfahren vorzugsweise ein Rest der oben definierten Formel VIII b.

Als Ausgangsmaterialien verwendet man im allgemeinen Polyimide mit niedrigem bis mittlerem Molekulargewicht; bevorzugte Ausgangspolyimide besitzen eine inhärente Viskosität von 0,2 bis 0,5 dl/g (gemessen als 0,5 %ige Lösung in NMP bei 25° C).

Die katalytische Hydrierung wird in der Regel in einem inerten Lösungsmittel vorgenommen, beispielsweise in einem Ether, wie Tetrahydrofuran. Al Hydrierungskatalysator verwendet man beispielsweise palladium-Kohle.

Die jeweiligen Reaktionsbedingungen und Katalysatoren sind an sich bekannt und beispielsweise in "Methoden der organischen Chemie", Bd. VI/lb, Teil 3, S. 50-61, G. Thieme Verlage (1984) beschrieben.

Die inhärente Viskosität von Polyimiden enthaltend mindestens 50 Mol% an Struktureinheiten der Formel I beträgt in der Regel 0,1-1,0 dl/g (gemessen an 0,5 gew.%igen Lösungen in NMP bei 25° C), bevorzugt 0,2-0,7 dl/g und besonders bevorzugt 0,3 - 0,5 dl/g.

Die inhärente Viskosität von Polyimiden enthaltend mindestens 50 Mol% an Struktureinheiten der Formel II beträgt vorzugsweise 0,5-2,0 dl/g (gemessen an 0,5 gew.%igen Lösungen in NMP bei 25° C), ganz besonders bevorzugt 0,6-1,5 dl/g.

Bevorzugt enthalten die erfindungsgemässen Zusammensetzungen 30-5 Gew.% der Komponente a) und 70-95 Gern.% der Komponente b), wobei die Gewichtsangaben auf die Gesamtmenge an a) und b) bezogen sind.

Mit den erfindungsgemässen Zusammensetzungen lassen sich Beschichtungen mit einer verbesserten Haftung herstellen, deren Photoempfindlichkeit im Vergleich zu den unmodifizierten photoempfindlichen Polyimidschichten nicht übermässig herabgesetzt ist; ausserdem ist die Verträglichkeit beider Polymerkomponenten gegeben, so dass homogene Beschichtungen entstehen und keine Auswaschungen nach dem Entwickeln auftreten.

Hierbei ist es insbesondere von Vorteil, dass die (Co)polyimide enthaltend das Strukturelement der Formel I nicht unbedingt die sehr hohen Molekulargewichte der unmodifizierten photoempfindlichen Polyimide besitzen müssen, was technisch relativ schwierig realisierbar wäre.

Gegenstand der Erfindung ist auch ein beschichtetes Material bestehend aus

i) einem Substrat und

ii) mindestens einer darüberliegenden Schicht aus einer Zusammensetzung enthaltend die Komponente a) und b) wie oben definiert.

Beschichtungsmittel werden insbesondere in Form von Lösungen der erfindungsgemässen Gemische aus Komponente a), b) und einem Lösungsmittel eingesetzt.

Zur Herstellung des erfindungsgemäss beschichteten Materials löst man beide Komponenten zweckmässig in einem geeigneten organischen Lösungsmittel, gegebenenfalls unter Erwärmung.

Geeignete Lösungsmittel sind z.B. polare, aprotische Lösungsmittel, die allein oder in Mischungen aus mindestens zwei Lösungsmitteln verwendet werden können.

Beispiele sind: Ether, wie Dibutylether, Tetrahydrofuran, Dioxan, Ethylenglykol, Dimelthylethylenglykol, Dimethyldiethylenglykol, Diethyldiethylenglykol und Dimethyltriethylenglykol; halogenierte Kohlenwasserstoffe, wie Methylenchlorid, Chloroform, 1,2-Dichlorethan, 1,1,1-Trichlorethan und 1,1,2,2-Tetrachlorethan; Carbonsäureester und Lactone, wie Essigsäureethylester, Propionsäuremethylester, Benzoesäureethylester, 2-Methoxyethylacetat, γ-Butyrolacton, δ-Valerolacton und Pivalolacton; Carbonsäureamide und Lactame, wie Formamid, Acetamid, N-Methylformamid, N,N-Dimethylformamid, N,N-Diethylformamid, N,N-Dimethylacetamid, N,N-Diethylacetamid, γ-Butyrolactam, ε-Caprolactam, N-Methylpyrrolidon, N-Hexylpyrrolidon, N-Acetylpyrrolidon, N-Methylcaprolactam, Tetramethylharnstoff und Hexamethylphosphorsäureamid; Sulfoxide, wie Dimethylsulfoxid; Sulfone, wie Dimethylsulfon, Diethylsulfon, Trimethylensulfon und Tetramethylensulfon; tertiäre Amine, wie Trimethylamin, Triethylamin, N-Methylpyrrolidin, N-Methylpiperidin und N-Methylmorpholin; substituierte Benzole, wie Chlorbenzol, Nitrobenzol, Phenole oder Kresole.

Ungelöste Anteile können durch Filtration, bevorzugt einer Druckfiltration, entfernt werden. Die Konzentration an Polymergemisch im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung.

Bei der Herstellung der Lösungen können weiter übliche Zusatzstoffe einverleibt werden, die die Lichtempfindlichkeit nicht negativ beeinflussen. Beispiele herfür sind Mattierungsmittel, Verlaufmittel, feinteilige Füllstoffe, Flammschutzmittel, optische Aufheller, Anitoxidantien, Stabilisatoren, Lichtschutzmittel, Farbstoffe, Pigmente, Haftvermittler und Antihalofarbstoffe, wie sie z.B. in der US-PS 4 349 619 beschrieben sind.

Das Beschichtungsmittel kann mittels üblichen Methoden wie Tauch-, Streich- und Sprühverfahren, Schleuder-, Kaskadenguss- und Vorhanggussbeschichtung, auf geeignete Substrate oder Trägermaterialien, aufgebracht werden.

Das Material ist lagerstabil, aber vorteilhaft vor Lichteinwirkung zu schützen.

Geeignete Trägermaterialien oder Substrate sind z.B. Kunststoffe, beispielsweise gehärtete Epoxidharze oder Polyimide, Metalle und Metallegierungen, beispielsweise Eisen, Aluminium, Kupfer, Silber, Gold oder Bronze, Halbmetalle, beispielsweise Wismuth, Halbleiter, beispielsweise Germanium, Silizium, oder Galliumarsenid, Keramik oder andere anorganische Materialien, beispielsweise $SiO_2$ oder $Si_3N_4$.

Bevorzugte Trägermaterialien sind Metalle, Halbleiter oder Keramik, insbesondere Kupfer und Silizium. Die Trägermaterialien können ihrerseits als Laminate vorliegen, beispielsweise als kupferkaschierte Epoxidplatte. Ferner bevorzugt man als Träger anorganische Materialien, wie $SiO_2$ und $Si_3N_4$ insbesondere bevorzugt man $SiO_2$ Oberflächen.

Die Substratoberflächen werden vorzugsweise vor der Beschichtung mit einem geeigneten Haftvermittler versehen, da die guten haftvermittelnden Eigenschaften des Polyimids der Formel I sich in der Regel erst nach einer Wärmebehandlung entwickeln.

Nach dem Beschichten wird Lösungsmittel gegebenenfalls durch Erwärmen und gegebenenfalls im Vakuum entfernt. Man erhält klebfreie, trockene und gleichmässige Filme. Die aufgebrachten Filme können je nach Anwendung Schichdicken bis ca. 100 $\mu m$ und mehr aufweisen.

Es besteht nun die Möglichkeit, direkt aus solchen Polyimidgemischen Reliefabbildungen herzustellen. Die Polymerschicht des erfindungsgemäss beschichteten Materials weist in der Regel eine für viele Anwendungsfälle ausreichende und teilweise hohe Lichtempfindlichkeit auf und sie kann direkt photovernetzt werden. Durch die Direktvernetzung unter Strahlungseinwirkung können niedermolekulare Zusätze wie Sensibilisatoren vermieden werden und die Schutzschichten, Abbildungen und Filme weisen ausgezeichnete elektrische Eigenschaften auf. Ferner zeichnen sie sich durch hohe Haftfestigkeit und thermische, mechanische und chemische Widerstandsfähigkeit aus. Bei thermischen Nachbehandlungen wird nur ein geringer Schwund beobachtet, was in der Anwendung erhebliche Vorteil hat, weil praktisch keine Verzerrung abgebildeter Strukturen beobachtet wird bzw. weil keine inneren Spannungen in Ueberzügen und Filmen entstehen.

Schutzfilme aus diesen Polyimidgemischen können durch Wärme oder durch Strahlungseinwirkung weiter modifiziert werden, womit z.B. noch weiter erhöhte Haftfestigkeiten und Thermostabilitäten möglich sind.

Die Herstellung von Schutzfilmen erfolgt in der Regel durch direktes Belichten, wobei sich die Belichtungszeiten im wesentlichen nach den Schichtdicken und der Lichtempfindlichkeit richten und vom Fachmann mittels üblicher Verfahren bestimmt werden können.

Die photographische Erzeugung der Reliefstrukturen erfolgt in der Regel durch bildmässige Belichtung durch eine Photomaske, anschliessende Entwicklung unter Entfernung der unbelichteten Anteile mit einem Lösungsmittel oder einem Lösungsmittelgemisch. Anschliessend wird der belichtete Schutzfilm oder das erzeugte Bild gegebenenfalls durch weiteres Bestrahlen stabilisiert. Dann folgt in der Regel eine thermische Nachbehandlung, wobei sich die Substrathaftung beträchtlich vergrössert. Dazu wird die Probe im allgemeinen oberhalb von 150° C getempert; die Temperaturen können bei diesem Schritt bis zu 300° C betragen.

Zum Gegenstand der Erfindung zählt auch ein Verfahren zur Herstellung von Schutzüberzügen umfassend die Schritte

i) Beschichten eines Trägermaterials mit einer Zusammensetzung enthaltend die Komponenten a) und b), wie oben definiert, gegebenenfalls unter Verwendung eines Haftvermittlers,

ii) Bestrahlen des beschichteten Materials mit aktinischer Strahlung, so dass die Polymerschicht in ihrer gesamten Fläche vernetzt wird,

iii) gegebenenfalls photochemische Nachbehandlung und

iv) thermische Nachbehandlung.

Ferner betrifft die Erfindung ein Verfahren zur Herstellung von Reliefstrukturen umfassend die Schritte

i) Beschichten eines Trägermaterials mit einer Zusammensetzung enthaltend die Komponenten a) und b), wie oben definiert, gegebenenfalls unter Verwendung eines Haftvermittlers,

ii) Bestrahlen des beschichteten Materials mit einem Muster aktinischer Strahlung, so dass die bestrahlten Stellen besagter Polymerschicht vernetzt werden,

iii) Entwickeln des Systems mit einem geeigneten Entwickler in an sich bekannter Weise,

iv) gegebenenfalls photochemische Nachbehandlung,

v) thermische Nachbehandlung und

vi) gegebenenfalls Behandlung des beschichteten Substrats mit einem Aetzmittel in an sich bekannter Weise.

Zum Gegenstand der Erfindung zählen ferner die durch Strahlungsvernetzung erhaltenen Schutzüberzüge und Reliefabbildungen.

Die Photostrukturierung bzw. Photovernetzung kann durch aktinische Strahlung hervorgerufen werden, z.B. durch UV-Licht, Röntgenstrahlen, Laserlicht oder Elektronenstrahlen.

Anwendungsgebiete sind z.B. Schutz-, Isolier- und Passivierlacke in der Elektrotechnik und Elektronik, Photomasken für die Elektronik, den Textildruck und das graphische Gewerbe, Aetzresist zur Herstellung gedruckter Schaltungen und Druckplatten und integrierter Schaltkreise, Relais für die Herstellung von Röntgenmasken, als Lötstopplack, als Dielektrikum für Mehrlagenschaltungen, als Strukturelement für Flüssigkristallanzeiger.

Zum Gegenstand dieser Erfindung zählt auch die Verwendung des oben definierten beschichteten Materials zur Herstellung von Isolier-, Passivier- und Schutzschichten und von Reliefabbildungen. Die Schichtdicke der Polymerschicht beträgt für diese Anwendungen bevorzugt 0,5 bis 100 µm, besonders 1 bis 50 µm und insbesondere 1 bis 10 µm.

## Beispiele

### 1. Herstellung von Polyimiden enthaltend Benzhydroltetracarbonsäurereste (Komponente a)

### 1.1. Herstellung der Komponente a) über Polykondensation

Das Isomerengemisch des 3,3'-4,4'-Benzhydroltetracarbonsäure-dimethylesters (BTDA-$H_2$) wird entsprechend der Vorschrift aus "Proceedings of Second Int. Conf. on Polyimides", S. 75-85 (1985) hergestellt und isoliert.

Sodann werden unter Stickstoff
3,90 g BTDA-$H_2$ (0.01 Mol)
2,54 g 3,3',5,5'-Tetramethyldiaminodiphenylmethan (0,01 Mol) in 23 ml NMP
vereinigt und auf 180 °C erhitzt. Nach ca. 2 h ist keine Methanolabspaltung mehr zu beobachten. Die Mischung wird weiter 2 h bei 200 °C belassen und dann abgekühlt. Nach Ausfällen in Wasser, Waschen und Trocknen bei 80 °C in Vakuum werden 5,2 g des Polymeren 1 erhalten, das sich gut in Lösungsmitteln wie N-Methylpyrrolidon, 4-Butyrolacton, Cyclopentanon auflöst.

Physikalische Daten:
$T_g$: 313-315 °C;
$\eta_{inh}$ (0,5 % in NMP bei 25 °C): 0,374 (dl/g);

$$\text{NMR } (-\underset{\text{OH}}{\text{CH}}-)\text{: 6,23 ppm.}$$

### 1.2 Herstellung der Komponente a) über Hydrierung von Benzophenontetracarbonsäuredianhydrid-Polyimiden

Gemäss EP-A-0132221 (Beispiel 6) wird 4,4'-Diamino-3,3',5,5'-tetramethyldiphenylketon mit einer äquivalenten Menge Benzophenontetracarbonsäuredianhydrid umgesetzt und anschliessend zum Polyimid cyclisiert.

Physikalische Daten:
$T_g$: 293-313 °C;
$\eta_{inh}$ (0,5 % in NMP bei 25 °C): 0,246 dl/g;
$^1$H-NMR (DMSO-$d_6$): Benzophenontetracarbonsäurerest (6): 8.20 - 8.40 ppm;
4,4'-Diamino-3,3',5,5'-tetramethyldiphenylketonrest (4): 7,46 ppm;
IR: Imid-Carbonyle: 1720 $cm^{-1}$;
Diaryl Ketone: 1666 $cm^{-1}$.

4 g des erhaltenen Polymeren werden in 80 ml THF gelöst und in einer Hydrier-Schüttelapparatur mit 800 mg Pd/C, 5 % versetzt. Man lässt bei 30-35 °C unter $H_2$ bei Normaldruck reagieren. Bei den Aufnahmewerten von 38 bzw. 117 % der Theorie werden nochmals je 800 mg des Katalysators zugesetzt, dann wird die Reaktion nach 94 h abgebrochen.

Man isoliert 3.2 g hydriertes Produkt durch Fällen in Wasser:
Physikalische Daten:

$\eta_{inh}$ (0,5 % in NMP bei 25° C): 0,21 dl/g;
$^1$H-NMR: - Benzhydroltetracarbonsäurerest (6) : 7,95-8,20 ppm;

- $(-\underset{OH}{CH}-)$, Benzhydroltetracarbonsäure: 6,27 ppm; 77 % der Theorie;
- $(-\underset{OH}{CH}-)$, Benzhydroltetracarbonsäure: 6,76 ppm; 77 % der Theorie;
- $(-CH_2-)$ aus Benzhydroltetracarbonsäure: 4,46 ppm; 19 % der Theorie;
- 4,4'-Diamino-3,3',5,5'-tetramethyldiphenylketonrest (4): 7,37 ppm 97 % der Theorie;
- $(-\underset{OH}{CH})-$ aus 4,4'-Diamino-3,3',5,5'-tetramethyldiphenylketon: 6,12 ppm; 12 % der Theorie;
- $(-\underset{OH}{CH}-)$ aus 4,4'-Diamino-3,3',5,5'-tetramethyldiphenylketon: 6,57 ppm; 12 % der Theorie;

IR: Imid-Carbonyle: 1720 $cm^{-1}$;
Diarylketon: 1663 $cm^{-1}$.

Das Polymere ist somit selektiv am Rest der Benzophenontetracarbonsäure hydriert worden, wohingegen die carbonylgruppe des Diaminrestes weitgehend erhalten geblieben ist.

2. Herstellung von photoempfindlichen Schichten aus Polyimidmischungen mit Komponente a)

2.1. Eine Photolacklösung, die - bezogen auf den Gesamtfeststoffgehalt - 20 % der Komponente a) enthält wird in folgender Weise hergestellt:

Polyimid (Komponente b) hergestellt aus:
- Benzophenontetracarbonsäuredianhydrid 100 %
- 1,4-Diaminotetramethylbenzol 55 %
- 4,4'-Diamino-3,3'-dimethyl-5,5'-diethyl-diphenylmethan 45 %

$\eta_{inh}$ (0,5 % in NMP bei 25° C): 0,97 (dl/g) 1,504 g
Komponente a) gemäss 1.1. 0,376 g
$\gamma$-Butyrolacton 18,120 g

Nach dem Filtrieren auf 0,45 µm kann man mit der erhaltenen Lösung auf Wafersubstraten 1,0 µm dicke Beschichtungen erzeugen, wenn man eine Drehzahl von 4'250 U/min (20 sec) verwendet.

2.2. Eine weitere Photolacklösung analog 2.1. wird in folgender Weise hergestellt:

Polyimid hergestellt aus:

\- 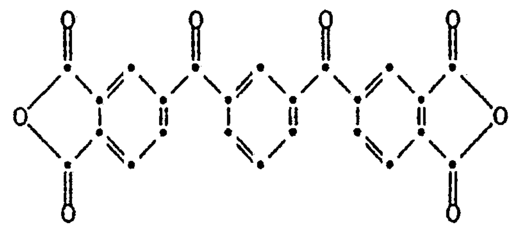 100 %

\- 4,4'-Diamino-3,3',5,5'-tetramethyldiphenylmethan 100 %

$\eta_{inh}$ (0,5 % in NMP bei 25 °C): 0,51 (dl/g) 0,757 g

Komponente a) gemäss 1.1 0,189 g

N-Methylpyrrolidon 7,713 g

Nach dem Filtrieren auf 0,45 µm kann man mit der erhaltenen Lösung auf Wafersubstraten 1,0 µm dicke Beschichtungen erzeugen,wenn man eine Drehzahl von 2'800 U/min (8 sec) verwendet.

2.3. Eine Photolacklösung, die bezüglich der zugesetzten Menge der Komponente a) einen relativ geringen Empfindlichkeitsverlust zeigt, wird in folgender Weise hergestellt:

Polyimid (Komponente b) identisch zu 1,19 g
Beispiel 2.1 ($\eta_{inh}$ = 0,97 dl/g)

Hydriertes Polymer (Komponente a) des Herstellungs- 0,51 g
beispiels 1.2. ($\eta_{inh}$ = 0,21 dl/g)

γ-Butyrolacton 18,30 g

Nach dem Filtrieren auf 0.2 µm kann man mit der erhaltenen Lösung auf Wafersubstraten 1,10 µm dicke Beschichtungen erzeugen, wenn man eine Drehzahl von 3'150 U/min (8 sec) verwendet. Auch nach einer Lagerzeit von 7 Monaten bei Raumtemperatur zeigt diese Lösung praktisch unveränderte Verarbeitungsbedingungen.

3. Herstellung von Reliefstrukturen, die unter Aetzbedingungen auf $SiO_2$-Schichten haften

3.1. Auf Siliziumwafern mit einer 1275 Å starken $SiO_2$-Schicht, die nach der Oxidation ca. 3 Wochen gelagert sind, werden Reliefstrukturen mit einer Schichtstärke von 1,0 µm nach folgendem Prozess erzeugt:

I. Aufschleudern einer Lösung des Haftvermittlers γ-Aminopropyltriethoxysilan.

II. Aufschleudern der Lösung unter 2.1 bei 4250 U/min.

III. Trocknung bei 90 °C, 30 min auf einem "Hotplate".

IV. Belichtung mittels einer Maskenjustier- und Belichtungsmaschine durch eine Testmaske mit hochaufgelösten Strukturen (mit Gräben und Stegen der Breite 2,0 und 3,0 µm) und einer Gesamtbelichtungsleistung von 1025 mJ/cm² bezogen auf die 400 nm Messonde der Firma OAI, Optical Associates Inc.

V. Entwicklung durch Aufsprühen von Cyclopentanon, 18 sec.

VI. Erhitzen auf 280 °C (15 min, 45 min Aufheizphase) und Abkühlen.

VII. Plasma-Reinigung im $O_2$-Plasma, 1 min.

Beim anschliessenden Aetz- und Strip-Prozess:

- 2 min 30 sec. Eintauchen in eine Lösung hergestellt aus
  Flussäure (HF) 40 %, 100 ml
  $NH_4F$ 40 %, 1000 ml
- Eintauchen in Ethanolamin
  100 °C, 15 min

wird folgendes beobachtet:

A) Nach dem Eintauchen in die Flusssäure-Aetzlösung sind keinerlei Ablösungen der 2,0 und 3,0 µm breiten Polyimidreliefstrukturen zu beobachten.

B) Nach dem Strippen der Polyimidschicht werden klare Aetzmuster in der $SiO_2$-Schicht sichtbar, so dass die durch die 2,0 und 3,0 µm breiten Stege abgedeckten Bereiche zwar verjüngt sind, aber als freistehende Linienstrukturen deutlich zu erkennen sind.

3.2. Mit der Photolacklösung der Herstellungsbeispiels 2.2 werden analog 3.1 Reliefstrukturen der Schichtstärke 1,0 µm auf $SiO_2$-Schichten erzeugt, wobei man abweichend zu 3.1

- bei 2'800 U/min aufschleudert
- mit einer Gesamtbelichtungsleistung von 9350 mJ/cm² belichtet
- 40 sec mit Cyclopentanon entwickelt

ansonsten aber alle Prozesschritte völlig analog zu 3.1 durchführt.

Nach dem anschliessenden Aetz- und Strip-Prozess beobachtet man ebenfalls:

A) Nach dem Eintauchen in die Flussäure-Aetzlösung sind keinerlei Ablösungen der 2,0 und 3,0 µm breiten Polyimidreliefstrukturen zu beobachten.

B) Nach dem Strippen der Polyimidschicht werden klare Aetzmuster in der $SiO_2$-Schicht sichtbar, so dass die durch die 3,0 µm breiten Stege abgedeckten Bereiche zwar verjüngt sind, aber als freistehende Linienstrukturen deutlich zu erkennen sind.

3.3. Nach 7-monatiger Lagerung bei Raumtemperatur verwendet man die Photolacklösung des Herstellungsbeispiels 2.3., um auf Siliziumwafern, die mit 1275 Å $SiO_2$ beschichtet sind, Reliefstrukturen der Schichtstärke 1,10 µm herzustellen.

Abweichend von 3.1. wählt man folgende Bedingungen:

- Die über längere Zeit gelagerten $SiO_2$-beschichteten Wafer werden zuerst 5 Min. lang in einem $O_2$-Plasma gereinigt.
- Die Photolacklösung wird 8 sec. lang bei 3150 U/Min. aufgeschleudert.
- Die Trocknung erfolgt 15 Min. lang bei 90° C.
- Enwickelt wird durch Aufsprühen von Cyclopentanon 15 Sek. lang.
- Die Plasma-Reinigung erfolgt 30 sec. lang.
- Beim Aetzprozess werden die Wafer 2 Min. 15 Sek. in eine Lösung hergestellt aus Flusssäure (HF) 40 %, 100 ml $NH_4F$ 40 %, 1000 ml eingetaucht.

Ansonsten wird der Prozess völlig analog 3.1. durchgeführt.

Es wird jedoch nur eine Belichtungsenergie von 760 mJ/cm$^2$ benötigt, um ein getreues Polyimid-Abbild der Maske zu erzeugen.

Nach dem Eintauchen in die Flusssäure-Aetzlösung sind keinerlei Ablösungen der 2,0 und 3,0 µm breiten Feinstrukturen zu erkennen.

Nach dem Strippen der Polyimidschicht werden klare Aetzmuster in der $SiO_2$-Schicht sichtbar, so dass die durch die 2,0 und 3,0 µm breiten Stege abgedeckten Bereiche zwar verjüngt sind, aber als freistehende Linienstrukturen deutlich zu erkennen sind.

Der Rand der Aetzmuster lässt einen kontrollierten lateralen Verlauf der Aetzung erkennen.

## Patentansprüche

**1.** Zusammensetzungen enthaltend

a) 50-1 Gew.%, bezogen auf die Gesamtmenge aus a) und b), mindestens eines Polyimids mit einer inhärenten Viskosität von mindestens 0,1 dl/g (gemessen an einer 0,5 gew.%igen Lösung in N-Methylpyrrolidon bei 25° C) enthaltend mindestens 50 Mol% an Struktureinheiten der Formel I

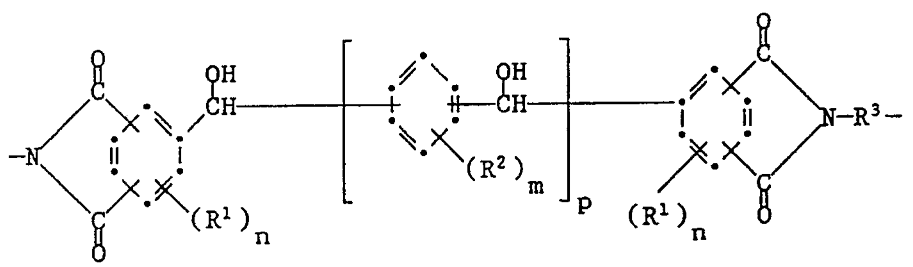 (I),

worin m und p unabhängig voneinander ganze Zahlen von 0 bis 4 und n eine ganze Zahl von 0 bis 3 bedeuten,

$R^1$ und $R^2$ unabhängig voneinander $C_1$-$C_6$-Alkyl oder $C_1$-$C_6$-Alkoxy bedeuten und

$R^3$ ein zweiwertiger Rest eines aromatischen Diamins ist, der in wenigstens einer Orthostellung zu wenigstens einem N-Atom durch Alkyl, Alkoxy, Alkoxyalkyl, Cycloalkyl oder Aralkyl substituiert ist, oder bei dem zwei benachbarte C-Atome des aromatischen Restes durch Alkylen substituiert sind, und

b) 50-99 Gew.%, bezogen auf die Gesamtmenge aus a) und b), mindestens eines in organischen Lösungsmitteln löslichen und photovernetzbaren aromatischen Polyimids, das wenigstens 50 Mol% an Strukturelementen der Formel II

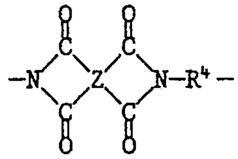 (II),

enthält, worin Z ein vierwertiger aromatischer Rest der Formeln III, IV, V und/oder VI ist, bei dem jeweils zwei der freien Valenzen in ortho-oder peri-Stellung zueinander gebunden sind

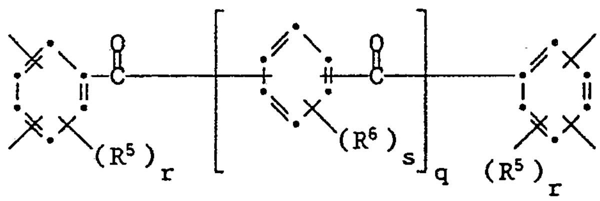 (III),

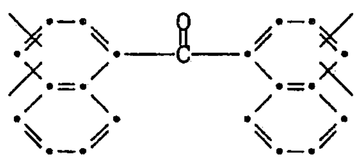 (IV),

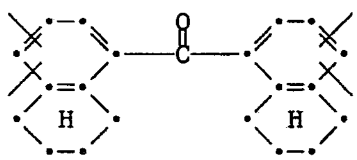 (V), 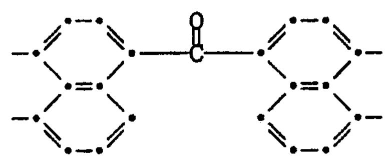 (VI),

worin $R^5$ und $R^6$ unabhängig voneinander $C_1$-$C_6$-Alkyl oder $C_1$-$C_6$-Alkoxy sind,
q und s unabhängig voneinander ganze Zahlen von 0 bis 4 bedeuten,
r eine ganze Zahl von 0 bis 3 ist, und
$R^4$ ein zweiwertiger Rest eines aromatischen Diamins ist, der in zwei Orthostellungen zu wenigstens einem N-Atom durch Alkyl, Alkoxy, Alkoxyalkyl, Cycloalkyl oder Aralkyl substituiert ist, oder bei dem zwei benachbarte C-Atome des aromatischen Restes durch Alkylen substituiert sind, und
c) als Cokomponente für a) und b) aromatische Polyimidreste der Formel IIa

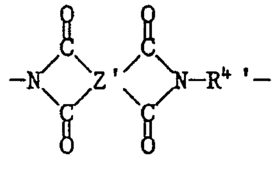 (IIa),

worin Z' ein vierwertiger aromatischer Rest der Formeln

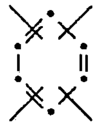 , 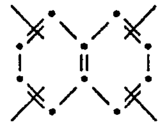 ,

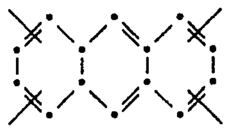 , 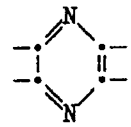 , 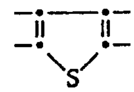

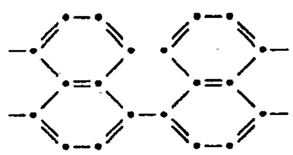 , 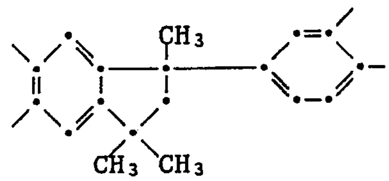

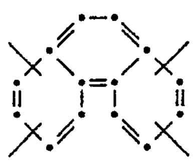 oder 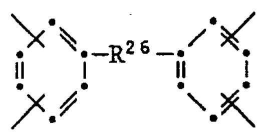

ist, in denen sich jeweils zwei der freien Valenzen in ortho- oder peri-Stellung zueinander befinden und worin $R^{26}$ eine direkte Bindung oder eine Brückengruppe der Formeln $-CH_2-$, $-C(CH_3)_2-$, -O-, -S-, $-SO_2-$, -NH-, $-C(CF_3)_2-$ oder $-Si(CH_3)_2-$ist, und $R^{4'}$ ein zweiwertiger aromatischer Kohlenwasserstoffrest mit 6 bis 24 C-Atomen ist.

**2.** Zusammensetzungen gemäss Anspruch 1 enthaltend als Komponente b) mindestens ein Polyimid enthaltend wenigstens 90 Mol% an Strukturelementen der Formel II, worin Z ein Rest der Formel IIIa, IIIb oder IIIc ist oder ein Gemisch dieser Reste ist

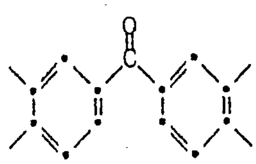 (IIIa), 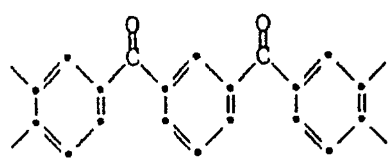 (IIIb),

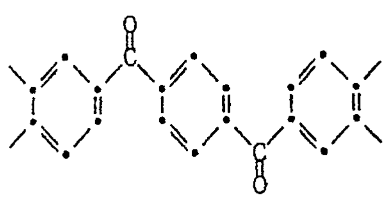 (IIIc),

und worin $R^4$ ein zweiwertiger Rest eines aromatischen Diamins ist, der in zwei Orthostellungen zu wenigstens einem N-Atom durch $C_1$-$C_6$-Alkyl substituiert ist.

**3.** Zusammensetzungen gemäss Anspruch 1, worin $R^4$ ein Rest der Formeln VII, VIII und/oder IX ist

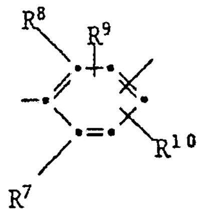 (VII),

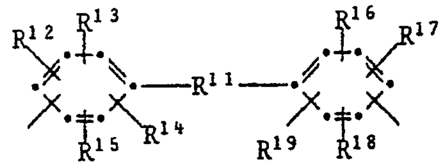 (VIII),

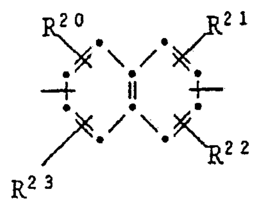 (IX),

worin die Reste $R^7$ bis $R^{10}$ und $R^{12}$ bis $R^{23}$ unabhängig voneinander Wasserstoff oder $C_1$-$C_6$-Alkyl sind und $R^{11}$ eine direkte C-C Bindung, $-CH_2-$, $-C(CH_3)_2-$, $-C(CF_3)_2-$, -O-, -CO- oder $-SO_2-$ ist, mit der Massgabe, dass jeder Rest der Formel VII, VIII, oder IX wenigstens zwei $C_1$-$C_6$-Alkylreste besitzt, die in Orthostellungen zu einer freien Valenz gebunden sind.

4. Zusammensetzungen gemäss Anspruch 1, enthaltend als Komponente b) Polyimide, die wenigstens 90 Mol% an Strukturelementen der Formel II enthalten, worin $R^4$ ein Rest der Formeln VIIa, VIIb, VIIc oder VIIIa ist oder ein Gemisch solcher Reste ist

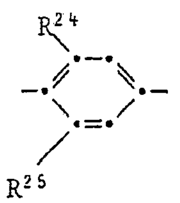 (VIIa),

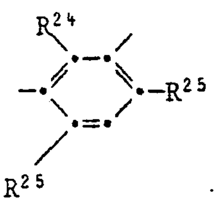 (VIIb),

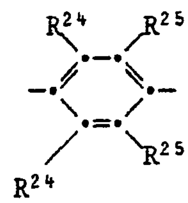 (VIIc),

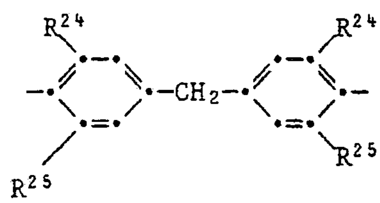 (VIIIa),

worin $R^{24}$ und $R^{25}$ $C_1$-$C_6$-Alkyl bedeuten.

5. Zusammensetzungen gemäss Anspruch 1, worin p 0 oder 1 ist, $R^3$ ein Rest der Formel VIII gemäss Anspruch 3 ist und $R^{11}$ -CO- bedeutet.

6. Polyimide enthaltend mindestens 50 Mol% an Struktureinheiten der Formel I gemäss Anspruch 1, worin $R^3$ ein zweiwertiger Reste eines aromatischen Diamins ist, der in zwei Orthostellungen zu wenigstens einem N-Atom durch Alkyl, Alkoxy, Alkoxyalkyl, Cycloalkyl oder Aralkyl substituiert ist, oder bei dem zwei benachbarte C-Atome des aromatischen Restes durch Alkylen substituiert sind.

7. Polyimide gemäss Anspruch 6, enthaltend mindestens 50 Mol% der Struktureinheiten der Formel X, XI und/oder XII

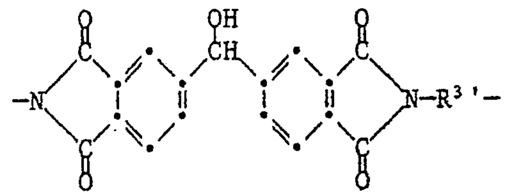 (X),

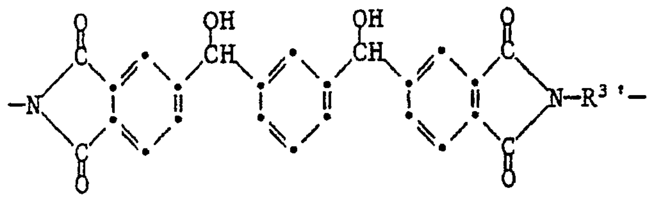 (XI),

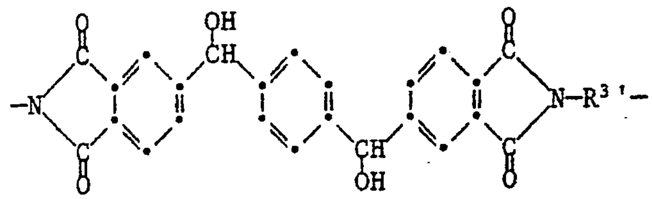 (XII),

worin $R^{3'}$ die für $R^4$ gemäss Anspruch 1 definierte Bedeutung besitzt.

**8.** Polyimide gemäss Anspruch 6, worin $R^3$ ein Rest der Formeln VII, VIII und IX gemäss Anspruch 3 ist.

**9.** Polyimide gemäss Anspruch 6, worin $R^3$ ein Rest der Formel VIII gemäss Anspruch 3 ist und $R^{11}$ -CO- bedeutet.

**10.** Verfahren zur Herstellung von Polyimiden enthaltend mindestens 50 Mol% an Struktureinheiten der Formel I gemäss Anspruch 1, umfassend die katalytische Hydrierung von Polyimiden enthaltend mindestens 50 Mol% an Struktureinheiten der Formel Ia

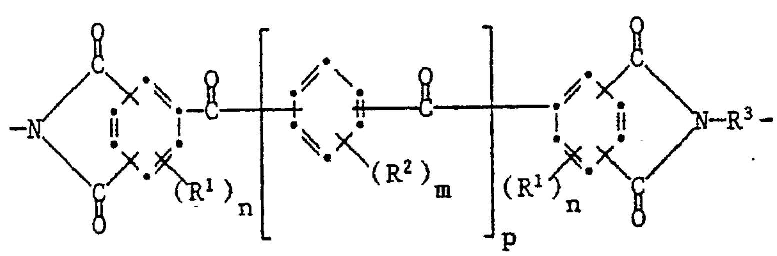 (Ia);

worin die Reste $R^1$, $R^2$ und $R^3$ sowie die Indizes m, n und p die in Anspruch 1 definierte Bedeutung besitzen.

**11.** Verfahren zur Herstellung von Schutzüberzügen umfassend die Schritte
i) Beschichten eines Trägermaterials mit einer Zusammensetzung gemäss Anspruch 1, gegebenenfalls unter Verwendung eines Haftvermittlers,
ii) Bestrahlen des beschichteten Materials mit aktinischer Strahlung, so dass die Polymerschicht in ihrer gesamten Fläche vernetzt wird,
iii) gegebenenfalls photochemische Nachbehandlung und
iv) thermische Nachbehandlung.

**12.** Verfahren zur Herstellung von Reliefstrukturen umfassend die Schritte

i) Beschichten eines Trägermaterials mit einer Zusammensetzung gemäss Anspruch 1, gegebenenfalls unter Verwendung eines Haftvermittlers,
ii) Bestrahlen des beschichteten Materials mit einem Muster aktinischer Strahlung, so dass die bestrahlten Stellen besagter Polymerschicht vernetzt werden,
iii) Entwickeln des Systems mit einem geeigneten Entwickler in an sich bekannter Weise,
iv) gegebenenfalls photochemische Nachbehandlung,
v) thermische Nachbehandlung und
vi) gegebenenfalls Behandlung des beschichteten Substrats mit einem Aetzmittel in an sich bekannter Weise.

**13.** Verwendung der Zusammensetzung gemäss Anspruch 1 zur Herstellung von Isolier-, Passivier- und Schutzschichten und von Reliefabbildungen.

## Claims

**1.** A composition comprising
a) 50-1% by weight, based on the total amount of a) and b), of at least one polyimide having an inherent viscosity of at least 0.1 dl/g (measured at 25 °C on a 0.5% by weight solution in N-methylpyrrolidone) and containing at least 50 mol % of structural units of the formula I

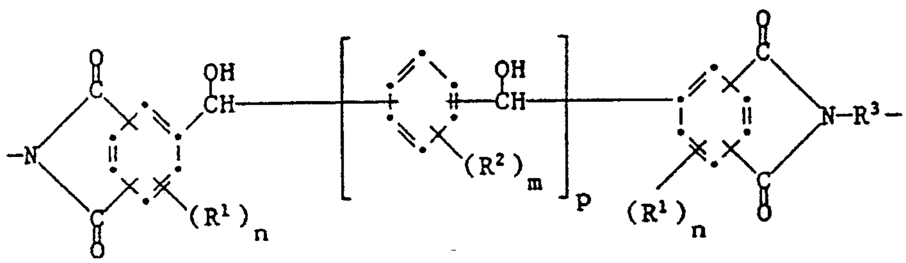

(I),

in which m and p independently of one another are integers from 0 to 4 and n is an integer from 0 to 3, $R^1$ and $R^2$ independently of one another are $C_1$-$C_6$alkyl or $C_1$-$C_6$alkoxy and $R^3$ is a divalent radical of an aromatic diamine which is substituted in at least one ortho-position relative to at least one N atom by alkyl, alkoxy, alkoxyalkyl, cycloalkyl or aralkyl or in which two adjacent C atoms of the aromatic radical are substituted by alkylene, and
b) 50-99% by weight, based on the total amount of a) and b), of at least one aromatic polyimide which is soluble in organic solvents and is photocrosslinkable and which contains at least 50 mol% of structural elements of the formula II

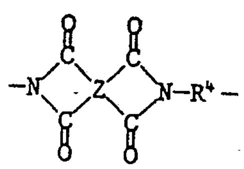

(II),

in which Z is a tetravalent aromatic radical of the formulae III, IV, V and/or VI, in which in each case two of the free valencies are bound in the ortho-position or peri-position relative to one another

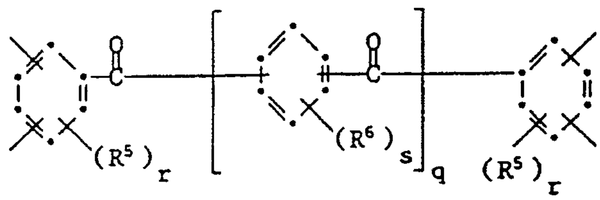

(III),

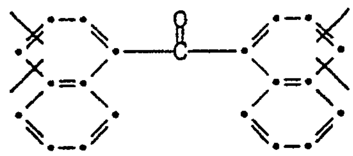

(IV),

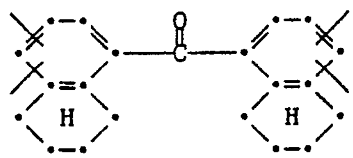

(V),

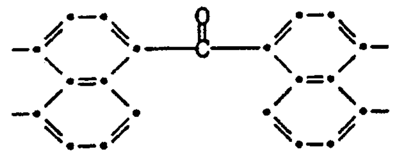

(VI),

in which $R^5$ and $R^6$ independently of one another are $C_1$-$C_6$alkyl or $C_1$-$C_6$alkoxy, q and s independently of one another are integers from 0 to 4, r is an integer from 0 to 3 and $R^4$ is a divalent radical of an aromatic diamine which is substituted in two ortho-positions relative to at least one N atom by alkyl, alkoxy, alkoxyalkyl, cycloalkyl or aralkyl, or in which two adjacent C atoms of the aromatic radical are substituted by alkylene, and

c) as co-components for a) and b), aromatic polyimide radicals of the formula IIa

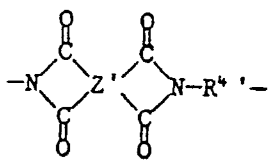

(IIa)

in which Z' is a tetravalent aromatic radical of the formula

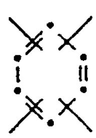

,

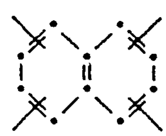

,

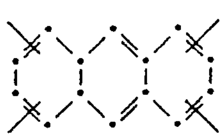

,

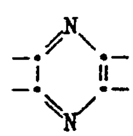

,

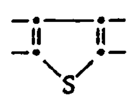

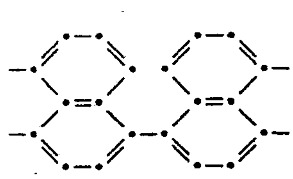 , 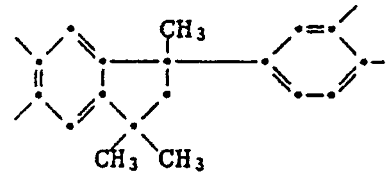

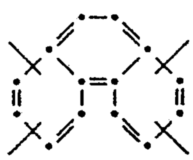 or 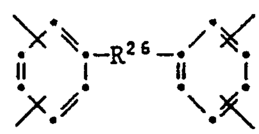

in which in each case two of the free valencies are in the ortho-position or peri-position relative to one another and in which $R^{26}$ is a direct bond or a bridge group of the formula $-CH_2-$, $-C(CH_3)_2-$, -O-, -s-, $-SO_2-$, NH-, $-C(CF_3)_2-$ or $-Si(CH_3)_2-$ and $R^{4'}$ is a divalent aromatic hydrocarbon radical having 6 to 24 C atoms.

**2.** A composition according to claim 1, containing as the component b) at least one polyimide which contains at least 90 mol % of structural elements of the formula II, in which Z is a radical of the formula IIIa, IIIb or IIIc or a mixture of these radicals

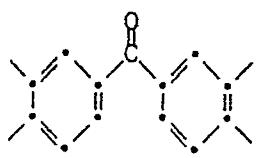 (IIIa), 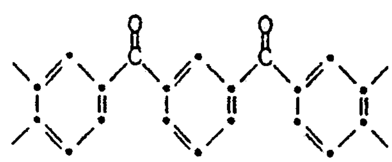 **(IIIb),**

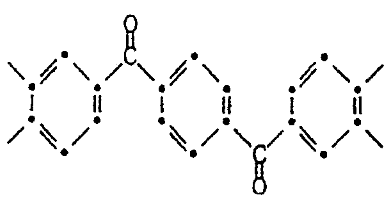 (IIIc),

and in which $R^4$ is a divalent radical of an aromatic diamine which is substituted in two ortho-positions relative to at least one N atom by $C_1$-$C_6$alkyl.

**3.** A composition according to claim 1, wherein $R^4$ is a radical of the formulae VII, VIII and/or IX

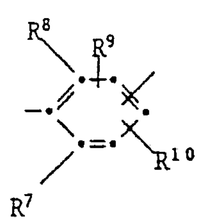 (VII), 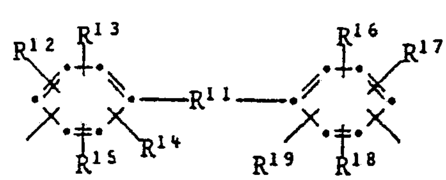 **(VIII),**

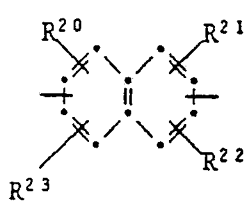 (IX),

in which the radicals $R^7$ to $R^{10}$ and $R^{12}$ to $R^{23}$ independently of one another are hydrogen or $C_1$-$C_6$alkyl

and $R^{11}$ is a direct C-C bond, $-CH_2-$, $-C(CH_3)_2-$, $-C(CF_3)_2-$, -O-, -CO- or $-SO_2-$, with the proviso that each radical of the formula VII, VIII or IX carries at least two $C_1$-$C_6$alkyl radicals which are bound in ortho-positions relative to a free valency.

4. A composition according to claim 1, containing as the component b) a polyimide which contains at least 90 mol % of structural elements of the formula II, in which $R^4$ is a radical of the formula VIIa, VIIb, VIIc or VIIIa or a mixture of such radicals

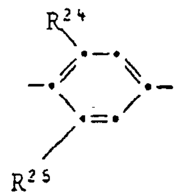 (VIIa), 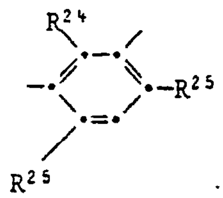 (VIIb), 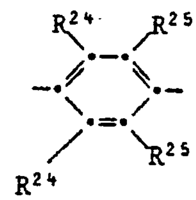 (VIIc)

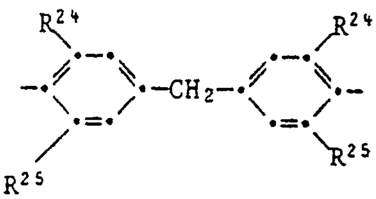 (VIIIa),

in which $R^{24}$ and $R^{25}$ are $C_1$-$C_6$alkyl.

5. A composition according to claim 1, wherein p is 0 or 1, $R^3$ is a radical of the formula VIII according to claim 3 and $R^{11}$ is -CO-.

6. A polyimide containing at least 50 mol % of structural units of the formula I according to claim 1, in which $R^3$ is a divalent radical of an aromatic diamine which is substituted in two ortho-positions relative to at least one N atom by alkyl, alkoxy, alkoxyalkyl, cycloalkyl or aralkyl or in which two adjacent C atoms of the aromatic radical are substituted by alkylene.

7. A polyimide according to claim 6, containing at least 50 mol % of structural units of the formula X, XI and/or XII

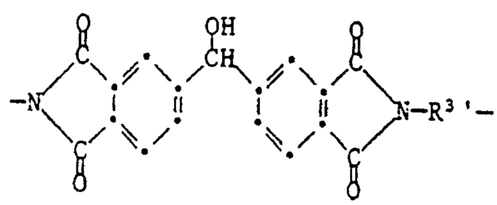 (X),

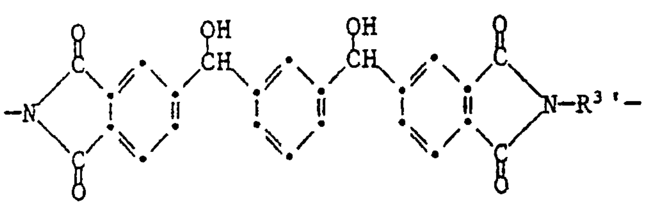 (XI),

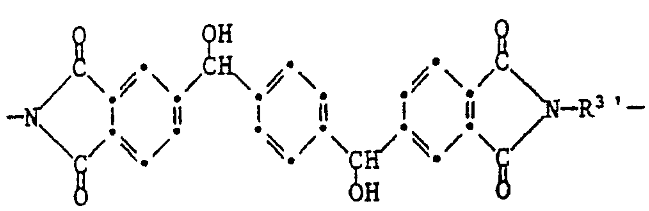 (XII),

in which $R^{3'}$ is as defined for $R^4$ in claim 1.

**8.** A polyimide according to claim 6, wherein $R^3$ is a radical of the formulae VII, VIII and IX according to claim 3.

**9.** A polyimide according to claim 6, wherein $R^3$ is a radical of the formula VIII according to claim 3 and $R^{11}$ is -CO-.

**10.** A process for the preparation of a polyimide comprising at least 50 mol % of structural units of the formula I according to claim 1, comprising the catalytic hydrogenation of a polyimide comprising at least 50 mol % of structural units of the formula Ia

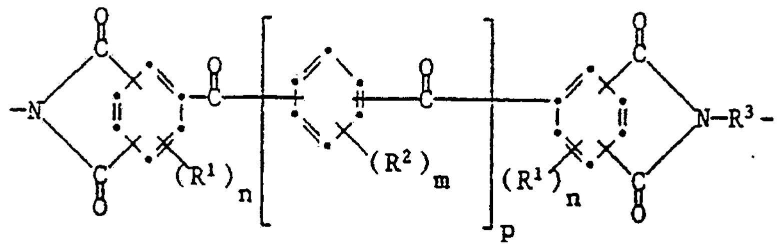
(Ia);

in which the radicals $R^1$, $R^2$ and $R^3$ and the indices m, n and p are as defined in claim 1.

**11.** A process for producing protective coatings, comprising the steps of
i) coating a carrier material with a composition according to claim 1, with the use of an adhesion promoter if necessary,
ii) irradiating the coated material with actinic radiation, so that the polymer layer is crosslinked over its entire area,
iii) photochemical aftertreatment, if necessary, and
iv) thermal aftertreatment.

**12.** A process for producing relief structures, which comprises the steps of
i) coating a carrier material with a composition according to claim 1, with the use of an adhesion promoter if appropriate,
ii) irradiating the coated material with a pattern of actinic radiation, so that the irradiated areas of the said polymer layer are crosslinked,
iii) developing the system with a suitable developer in a manner known per se,
iv) photochemical aftertreatment, if appropriate,
v) thermal aftertreatment and
vi) if appropriate, treatment of the coated substrate with an etching agent in a manner known per se.

**13.** The use of a composition as claimed in claim 1 for the production of insulating, passivating and protective coatings and of relief images.

## Revendications

**1.** Compositions contenant :
a) de 50 à 1 % en poids, par rapport à quantité totale de a) et b), d'au moins un polyimide ayant une viscosité inhérente d'au moins 0,1 dl/g (mesurée à 25 °C sur une solution à 0,5 % en poids dans de la N-méthyl-pyrrolidone) et renfermant au moins 50 % en moles de motifs structuraux répondant à la Formule I :

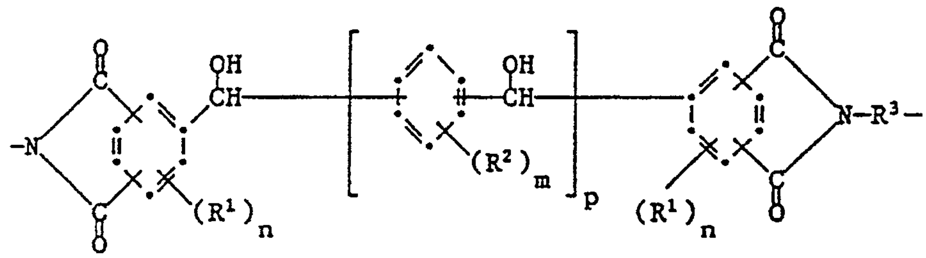

(I),

dans laquelle

m et p représentent chacun, indépendamment l'un de l'autre, un nombre entier de 0 à 4,

n représente un nombre entier de 0 à 3,

$R^1$ et $R^2$ représentent chacun, indépendamment l'un de l'autre, un alkyle en $C_1$-$C_6$ ou un alcoxy en $C_1$-$C_6$ et

$R^3$ représente un radical divalent d'une diamine aromatique qui porte un radical alkyle, alcoxy, alcoxyalkyle, cycloalkyle ou aralkyle en au moins une position ortho par rapport à au moins un atome N ou qui porte un alkylène lié à deux atomes C voisins appartenant au radical aromatique,

b) de 50 à 99 % en poids, par rapport à la quantité totale de a) et b), d'au moins un polyimide aromatique photoréticulable et soluble dans des solvants organiques qui renferme au moins 50 % en moles d'unités structurales répondant à la Formule II :

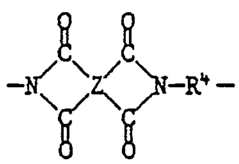

(II),

dans laquelle :

Z représente un radical aromatique quadrivalent qui répond à l'une des Formules III, IV, V et/ou VI, et dans lequel les deux valences libres de chacun des couples sont en ortho ou en péri l'une par rapport à l'autre :

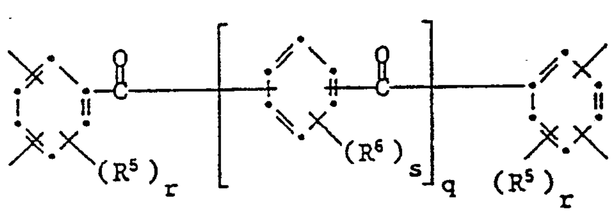

(III),

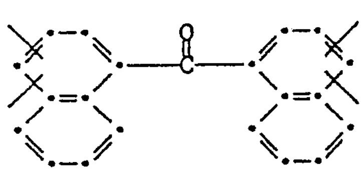

(IV),

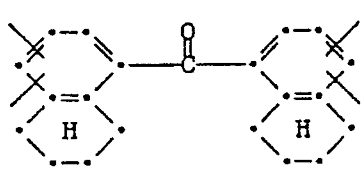

(V),

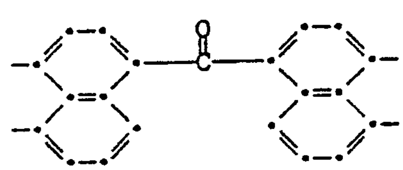

(VI),

où :

$R^5$ et $R^6$ représentent chacun, indépendamment l'un de l'autre, un alkyle en $C_1$-$C_6$ ou un alcoxy en $C_1$ $C_6$,

q et s représentent chacun, indépendamment l'un de l'autre, un nombre entier de 0 à 4, et

r représente un nombre entier de 0 à 3,

et

R4 représente un radical divalent d'une diamine aromatique qui porte un radical alkyle, alcoxy, alcoxy-alkyle, cycloalkyle ou aralkyle en deux positions ortho par rapport à au moins un atome N ou qui porte un alkylène lié à deux atomes C voisins appartenant au radical aromatique,

et

c) comme co-composante pour a) et b), des radicaux de polyimides aromatiques répondant à la Formule IIa :

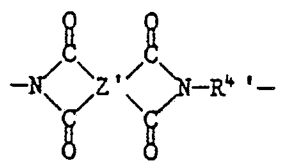

(IIa),

dans laquelle

Z' représente un radical aromatique quadrivalent répondant à l'une des formules :

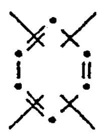

,

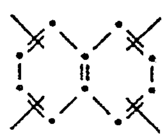

,

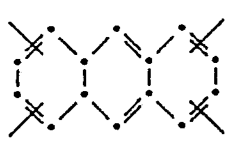

,

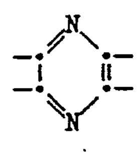

,

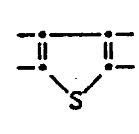

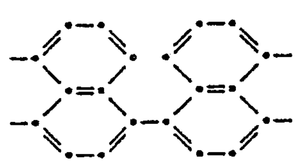

,

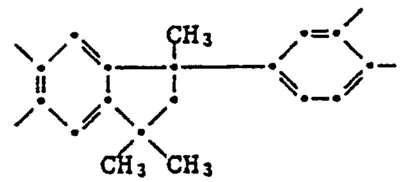

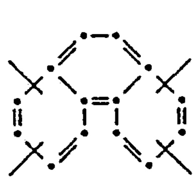

et

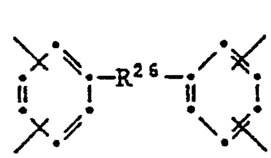

dans lesquelles les deux valences libres de chacun des couples sont en ortho ou en péri l'une par rapport à l'autre et $R^{26}$ représente une liaison directe ou un radical formant pont de formule $-CH_2-$, $-C(CH_3)_2-$, -O-, -S-, $-SO_2-$, -NH-; $-C(CF_3)_2-$ ou $-Si(CH_3)_2-$

et

$R^{4'}$ représente un radical hydrocarboné aromatique divalent qui contient de 6 à 24 atomes de carbone.

**2.** Compositions selon la revendication 1 qui contiennent, comme composante b), au moins un polyimide renfermant au moins 90 % en moles d'unités structurales de Formule II dans lesquelles Z représente un radical de Formule IIIa, IIIb ou IIIc ou un mélange de ces radicaux :

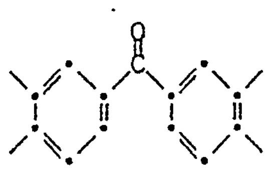 (IIIa), 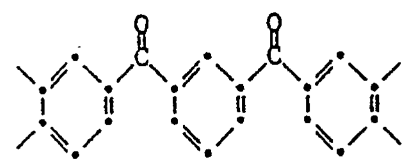 (IIIb),

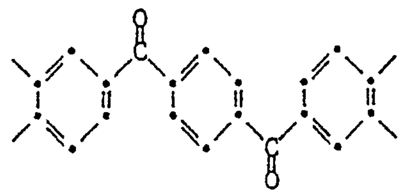 (IIIc),

et dans lesquelles $R^4$ représente un radical divalent d'une diamine aromatique qui porte un alkyle en $C_1$-$C_6$ en deux positions ortho par rapport à au moins un atome N.

**3.** Compositions selon la revendication 1 dans lesquelles $R^4$ représente un radical de Formules VII, VIII et/ou IX :

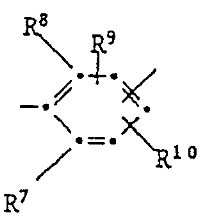 (VII), 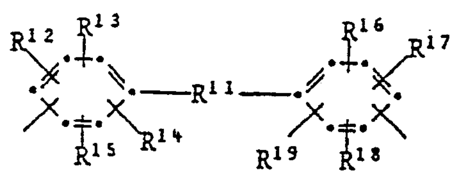 (VIII),

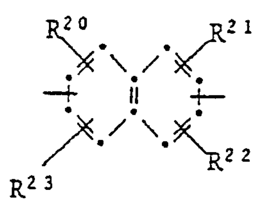 (IX),

dans lesquelles $R^7$ à $R^{10}$, et $R^{12}$ à $R^{23}$, représentent chacun, indépendamment les uns des autres, l'hydrogène ou un alkyle en $C_1$-$C_6$, et $R^{11}$ représente une liaison directe C-C, $-CH_2-$, $-C(CH_3)_2-$, $-C(CF_3)_2-$, -O-, -CO- ou $-SO_2-$, avec la condition que chacun des radicaux de Formules VII, VIII et IX porte au moins deux alkyles en $C_1$-$C_6$ se trouvant en des positions ortho par rapport à une valence libre.

**4.** Compositions selon la revendication 1 qui contiennent, comme composantes b), des polyimides renfermant au moins 90 % en moles d'unités structurales de Formule II dans lesquelles $R^4$ représente un radical répondant à l'une des Formules VIIa, VIIb, VIIc et VIIIa ou un mélange de tels radicaux :

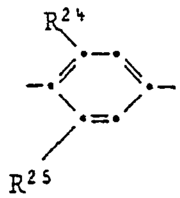 (VIIa), 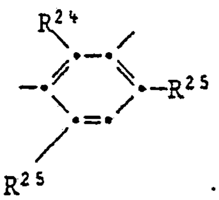 (VIIb), 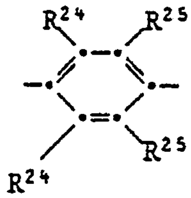 (VIIc),

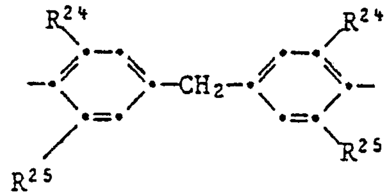 (VIIIa),

formules dans lesquelles $R^{24}$ et $R^{25}$ représentent chacun un alkyle en $C_1$-$C_6$.

**5.** Compositions selon la revendication 1 dans lesquelles p est égal à 0 ou à 1, $R^3$ représente un radical de formule VIII selon la revendication 3, et $R^{11}$ représente un radical -CO-,

**6.** Polyimides contenant au moins 50 % en moles d'unités structurales de Formule I selon la revendication 1 dans lesquelles $R^3$ représente un radical divalent d'une diamine aromatique qui porte, en deux positions ortho par rapport à au moins un atome N, un radical alkyle, alcoxy, alcoxy-alkyle, cycloalkyle ou aralkyle, ou dont deux atomes C voisins appartenant au radical aromatique portent un radical alkylène.

**7.** Polyimides selon la revendication 6 qui contiennent au moins 50 % en moles d'unités structurales de Formules X, XI et/ou XII :

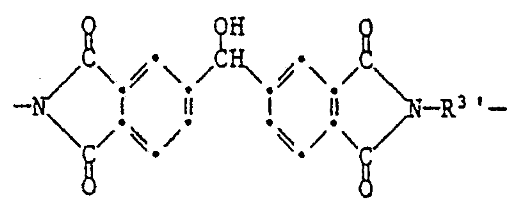 (X),

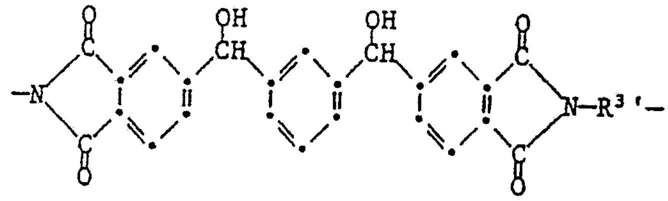 (XI),

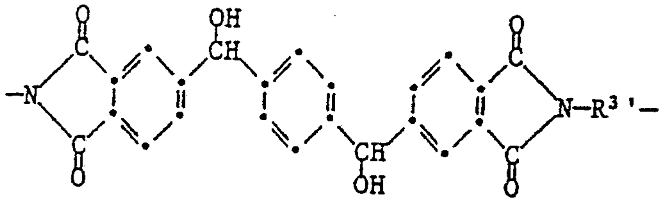 (XII),

dans lesquelles $R^{3'}$ a la signification qui a été donnée pour $R^4$ à la revendication 1.

**8.** Polyimides selon la revendication 6 dans lesquels $R^3$ représente un radical de Formule VII, VIII ou IX selon la revendication 3.

**9.** Polyimides selon la revendication 6 dans lesquels $R^3$ représente un radical de Formule VIII selon la revendication 3, et $R^{11}$ représente un radical -CO-.

**10.** Procédé pour préparer des polyimides contenant au moins 50 % en moles d'unités structurales de Formule I selon la revendication 1, procédé selon lequel on hydrogène catalytiquement des polyimides contenant au moins 50 % en moles d'unités structurales répondant à la Formule Ia :

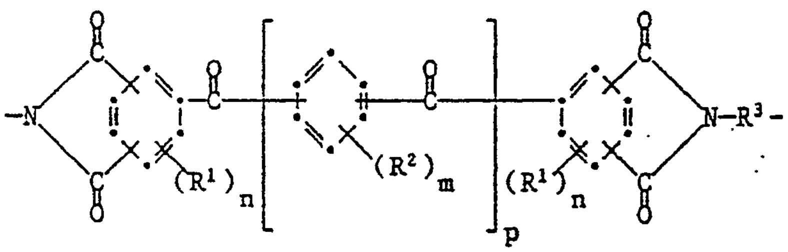

(Ia)

dans laquelle $R^1$, $R^2$, $R^3$, m, n et p ont les significations qui leur ont été données à la revendication 1.

**11.** Procédé pour fabriquer des revêtements protecteurs, procédé qui comprend les étapes suivantes :

I) on revêt une matière support avec une composition selon la revendication 1, éventuellement en utilisant un adjuvant d'adhérence,

II) on expose la matière revêtue à un rayonnement actinique de telle sorte que la couche polymère soit réticulée dans toute sa surface,

III) éventuellement on effectue un traitement complémentaire photochimique et

IV) on effectue un traitement complémentaire thermique.

**12.** Procédé pour fabriquer des structures en relief, procédé qui comprend les étapes suivantes :

I) on revêt une matière support avec une composition selon la revendication 1, éventuellement en utilisant un adjuvant d'adhérence,

II) on irradie la matière revêtue avec un dessin de rayonnement actinique de telle façon que les endroits de ladite couche polymère qui ont été touchés par le rayonnement soient réticulés,

III) on développe le système avec un développateur approprié, de manière connue,

IV) on effectue éventuellement un traitement complémentaire photochimique,

V) on effectue un traitement complémentaire thermique, et

VI) on traite éventuellement le substrat revêtu, de manière connue, par un agent d'attaque.

**13.** Application de la composition selon la revendication 1 à la fabrication de couches isolantes, passivantes et protectrices et d'images en relief.